# EUROPEAN PATENT APPLICATION

(11) **EP 0 939 342 A1**
(43) Date of publication of application: **01.09.1999**
(21) Application number: 99301341.6
(22) Date of filing: 24.02.1999
(51) Int. Cl.: G03F 7/20, G03F 7/40

(54) **Process for forming photoresist patterns**

(30) Priority: 25.02.1998 JP 4320898
(71) Applicant: Sharp Kabushiki Kaisha, Osaka-shi, Osaka 545-8522 (JP)
(72) Inventor: Okabe, Ichiro, Naka-ku, Yokohama-shi, Kanagawa 231-0045 (JP); Morosawa, Narihiro, Nara-shi, Nara 630-8441 (JP)
(74) Representative: Brown, Kenneth Richard

(57) **Abstract**

A process for forming a photoresist pattern comprises the steps of applying a chemical amplification type positive resist film on a layer to be etched, followed by exposing and developing, thereby to form a resist pattern, and irradiating an entire surface of the resist pattern with radiation having a single peak at a particular wavelength.

## Description

### BACKGROUND OF THE INVENTION

### 1.Field of the Invention

The present invention relates to a process for forming photoresist patterns, more particularly a process for forming photoresist patterns by lithography in manufacture of semiconductor devices and integrated circuits.

### 2.Description of Related Art

With growing sophistication of LSI technique in recent years, there is an increasing demand for formation of fine photoresist patterns. As finer patterns are becoming in use for production of semiconductor devices, radiation of wavelengths shorter than those of ultraviolet light is getting in use as a light source for forming photoresist patterns. In photolithography requiring a resolution of 0.25µm or less, a chemical amplification type resist film is now prevailing since it is highly sensitive and can provide high resolution. The conventional resist film in the previous generation is changed into soluble/insoluble parts only by exposure to light such as ultraviolet light. On the other hand, the recent resist film generates an acid by exposure to light in the presence of a catalyst and then the resulting acid acts to change the resist film into soluble/insoluble parts. That is, since the chemical amplification type resist film can react to weak light if an acid is generated, it is more sensitive than the conventional resist film.

The chemical amplification type resist film means a resist film containing at least an acid generator to generate an acid on exposure and a polymer which is reactive to the acid and has a low absorbance to light of wavelengths within a far ultraviolet range. As the polymer reactive to an acid of the chemical amplification type positive resist film, known is a compound having a main chain of polyvinylphenol (PVP), in which the OH group of the phenol moiety is protected by a protective group, as shown the following formula (1):

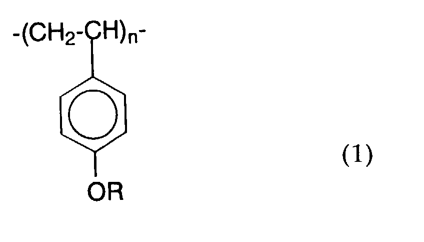

Here, examples of R include t-butoxycarbonyl (t-BOC), isopropoxycarbonyl (i-PrOC), tetrahydropyranyl (THP), trimethylsilyl (TMS), t-butoxycarbonylmethyl (t-BOC-CH₂), alkoxyalkyl, haloalkoxyalkyl, aralkyloxyalkyl groups and the like.

Taking a polymer in which the OH group of the phenol moiety is protected by t-BOC, for example, an acid generated from an acid generator by exposure causes the following reaction a post exposure baking treatment (hereafter referred to as PEB for abbreviation):

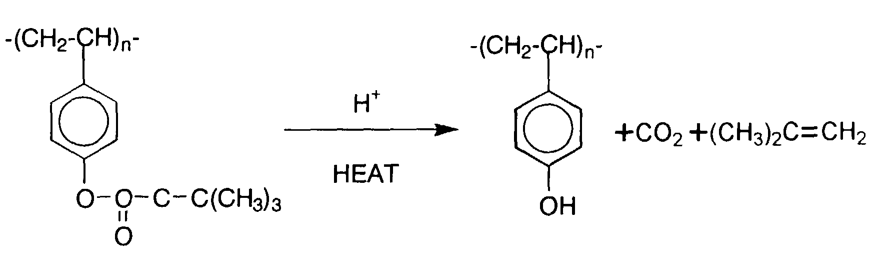

In this reaction, the acid serves as a catalyst. Accordingly, patterns can be formed with higher sensitivity and higher resolution compared with the conventional resist film.

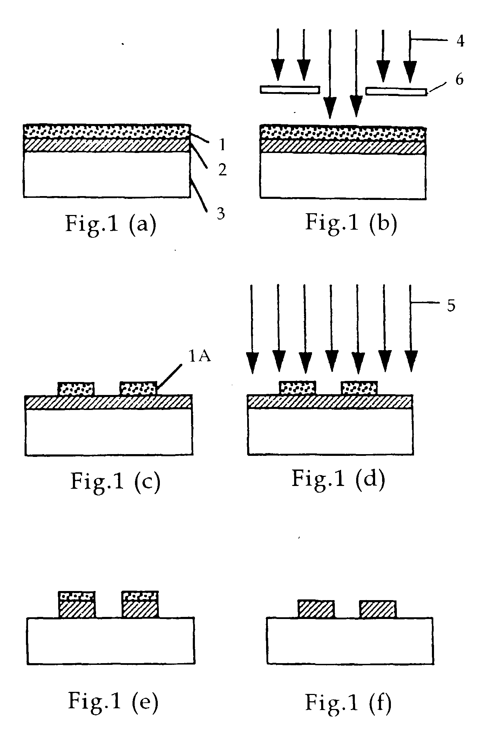

Now, with reference to Figs. 1(a) to 1(f), a process for forming a resist pattern using a typical chemical amplification type resist film is outlined, which is proposed in Japanese Unexamined Patent Publication No. HEI 6(1994)-214402.

First, a thin film 2 which is to be etched is formed on a semiconductor substrate 3 and then a resist film 1 is rotationally applied (see Fig. 1(a)). In the case where a light source used for patterning the resist film is a KrF excimer laser (having a wavelength of 248nm), the resist film 1 is formed of a resist film containing PVP as the main chain to whose OH group a dissolution inhibiting group is introduced. In the case where the light source is an ArF excimer laser (having a wavelength of 193nm), the resist film 1 is formed of a resist film containing a condensed alicyclic group or the like in a side chain. The resist film 1, which is formed by rotational application, is allowed to stand in an atmosphere of 90 to 110°C for around 70 to 120 seconds. This heating treatment step is hereafter referred to as a soft baking step.

Next, the resist film 1 is exposed to radiation 4 through a mask 6 for forming a desired pattern thereon (see Fig. 1(b)).

Subsequently, a heating treatment is performed at 90 to 110°C for about 90 seconds. This heating treatment step is the PEB. At this stage, a region of the resist film 1 where an acid is present becomes soluble to a developing liquid and a region where the acid is not present becomes insoluble to the developing liquid. After the PEB, development is carried out using a 2.38% tetramethylammonium (TMAH) aqueous solution as an alkali developing solution to form a resist pattern 1A (see Fig. 1(c)).

The formed resist pattern 1A is re-exposed to radiation to which the chemical amplification type resist film has absorption to light, e.g., far ultraviolet radiation (see Fig. 1(d)). Subsequently, the semiconductor substrate 3 is heated at a temperature of the glass transition point of the resist film or lower, i.e., 150 °C or lower.

Next, using the obtained resist pattern 1A as a mask, a thin film 2 is anisotropically etched to form a pattern (see Fig. 1(e)),and the resist pattern 1A is removed by ashing (see Fig. 1(f)).

As described above, by irradiating far ultraviolet radiation over the entire surface of the resist pattern after development and heating the resist pattern, a photoresist pattern having a high heat resistance and a high etching resistance can be obtained.

However, the inventors of the present invention have found that the irradiation of the chemical amplification type resist film with the above-mentioned far ultraviolet radiation and the heat treatment make it difficult to control post-etch line width of the resist pattern. For example, for stable production of high-density integrated circuits, the 3σ (variation in line width of the resist pattern) must be controlled to 20nm or below. According to the process of the above, however, 3σ with respect to a resist pattern having an intended line width of 240nm is 30nm. Thus, the conventional process for forming a photoresist pattern has difficulty in controlling the line width of the resist pattern accurately. Furthermore, by this method, there are found remains of the resist film after ashing.

It is considered that variation in the line width of the photoresist pattern by the above described process results from deformation of the photoresist pattern due to rise in the temperature of the resist film during the re-exposure using a light source such as a halogen lamp having various wavelengths including components of long wavelengths. It is also considered that the rise in the temperature of the resist pattern during the re-exposure gives rise to chemical substances which cannot be removed easily at ashing, which results in the remains of the resist film.

Thus, no processes for forming photoresist patterns have been found so far which can provide satisfactory performance regarding any of heating resistance, dry etching resistance, dimensional controllability and resist film release property.

### SUMMARY OF THE INVENTION

The present invention provides a process for forming a photoresist pattern including the steps of applying a chemical amplification type positive resist film on a layer to be etched, followed by exposing and developing, thereby to form a resist pattern and irradiating an entire surface of the resist pattern with radiation having a single peak at a particular wavelength.

According to the present invention, there is provided a process for forming a photoresist pattern which ensures an excellent dimensional controllability and a good resist film release property with maintaining heating resistance and dry etching resistance.

### BRIEF DESCRIPTION OF THE DRAWINGS

Figs. 1(a) to 1(f) are schematic sectional views illustrating a process for forming a resist pattern in accordance with the present invention;
Fig. 2 is a graph showing the relationship between etching rate and irradiation amount of radiation of a chemical amplification type resist film in accordance with the process of the present invention;
Fig. 3 is a graph showing the relationship between etching rate and temperature of heating a substrate after irradiation of a chemical amplification type resist film in accordance with the process of the present invention;
Fig. 4 is a graph showing the relationship between etching rate and refraction index to a wavelength of 633nm in a chemical amplification type resist film in accordance with the process of the present invention;
Fig. 5 is a graph showing the relationship between variations in line width and percentage of shrinkage in line width of a chemical amplification type resist film in accordance with the process of the present invention.

### DESCRIPTION OF THE PREFERRED EMBODIMENTS

In the process for forming a photoresist pattern of the present invention, a chemical amplification type positive resist film is first applied on a layer to be etched, followed by exposure and development, thereby to form a resist pattern.

The layer to be etched is a layer on which a pattern in a desired configuration is to be formed by photolithography and etching. This layer is typically formed on a semiconductor substrate directly or with intervention of one or more of a device such as a transistor or a capacitor, an insulating film, a conductive layer and the like, but may be a semiconductor substrate itself. The layer to be etched may be formed of a metal such as aluminum, copper, silver, gold or platinum, a high-melting point metal such as tungsten, tantalum, cobalt or titanium, an alloy containing such a metal, a polysilicon, a silicide or polycide composed of polysilicon and such a metal, or the like. The thickness of the layer is not particularly limited, but may be about 3000 to 8000 Å, for example.

The chemical amplification type positive resist film is applied onto the above described layer to be etched. Any chemical amplification type positive resist film may be used if it is ordinarily used in this field of art. Chemical amplification type positive resist films of this type are usually composed of an acid generator to generate an acid when exposed to radiation and a polymer reactive to the acid.

Examples of such polymers include compounds having the above-described formula (1) which have polyvinylphenol as the main chain, and in which the OH group of the phenol moiety is protected by t-butoxycarbonyl (t-BOC), isopropoxycarbonyl (i-PrOC), tetrahydropyranyl (THP), trimethylsilyl (TMS), t-butoxycarbonylmethyl (t-BOC-CH2), alkoxyalkyl (e.g., methoxymethyl, ethoxymethyl, propoxymethyl, methoxyethyl, ethoxyethyl, propoxyethyl, etc.), haloalkoxyalkyl, aralkyloxyalkyl and the like. Other polymers are also included.

Examples of the acid generator include onium salts, o-nitrobenzene esters, p-nitrobenzene esters, tri(methanesulfonyloxy)benzene and the like.

The chemical amplification type positive resist film may be applied to a thickness of about 3000 to 10000 Å by a known method, for example, by rotational application, by a doctor blade method or the like. Preferably, the surface of the layer to be etched is treated, for example, with hexamethyldisilazane or the like before the application of the resist film, thereby to be made lipophilic.

The exposure of the chemical amplification type positive resist film can be performed by irradiating ultraviolet radiation, electron radiation, X-radiation or the like with intervention of a mask against exposure having a pattern in a desired configuration.

The development of the chemical amplification type positive resist film can be performed using a developer which is ordinarily used for developing the resist film. For example, an aqueous solution of tetramethylammonium of about several percentage concentration and the like can be mentioned.

Then, the entire surface of the resist pattern obtained as described above is irradiated with radiation having a single peak at a particular wavelength.

Here, examples of radiation having a single peak at a particular wavelength include light from an UV lamp monochromatized by an optic filter, KrF excimer laser light (having a wavelength of 248nm), ArF excimer laser light (having a wavelength of 193nm), Xe excimer laser light (having a wavelength of 172nm), XeCl excimer laser light (having a wavelength of 308nm), electron radiation, X-radiation and the like. Particularly, it is preferable to use a light source having a peak at a wavelength whose energy can be absorbed by the acid generator such as sulfonium salt, diazo disulfone or the like. Especially ultraviolet radiation obtained from a KrF excimer laser, ArF excimer laser or the like is advantageous because it is easy to handle and highly monochromatic and it can induce the above-mentioned chemical reaction of the acid and the polymer efficiently. The reason why the radiation having a single peak at a particular wavelength is used is to prevent the dimensional controllability of the resist pattern from being declined due to a rise in the temperature of the resist pattern itself at the irradiation. The irradiation amount of radiation at this time is preferably about double or more the sensibility of the chemical amplification type positive resist film used, more preferably about twice to four times as large as the sensibility. Here, the sensibility means the minimum amount of radiation necessary for a good exposure to obtain a pattern of the chemical amplification type positive resist film after development. With an irradiation amount of radiation being double the sensibility or more, the reaction of eliminating the protective group of the polymer in the resist film can fully take place, and thereby the etching resistance of the resist pattern can be positively improved.

In the present invention, the whole layer to be etched including the resist pattern is preferably heated after the irradiation over the entire surface of the resist pattern. At this time, the layer to be etched is heated so that the resist pattern uniformly reaches a temperature of about 130 to 200°C, preferably about 150 to 200°C. This heating may be carried out for about 1 minute, for example, though heating time may be varied depending upon the configuration, the thickness or the like of the resist pattern. This heating can allow the acid generated from the acid generator to be diffused in the entire resist pattern. The acid acts to eliminate the protective group of the polymer effectively, which is not eliminated by mere irradiation of radiation. Thus the etching resistance of the resist film can be improved.

Further, in the present invention, the refraction index of the resist film to light is preferably increased by 3% or more, more preferably by about 3 to 10 %, after the irradiation of the resist pattern with the radiation, compared with that before the irradiation. The increase of the refraction index contributes to a sufficient eliminating reaction of the protective group of the polymer in the resist film and can positively improve the etching resistance of the resist pattern. As regards the refraction index of the resist film to light, light of any wavelength can be used if an ordinary thin-film interferometer can measure the refraction index thereof with good accuracy. For example, light having a wavelength of 633nm and the like can be mentioned. The refraction index of the resist film can be raised by adjusting the irradiation amount of radiation all over the resist pattern, the heating temperature, the heating time, the material of resist film and the like within the range described above.

Further, the line width of the resist pattern after the irradiation of the resist pattern with the radiation is preferably shrunk by 5% or more, more preferably by about 5 to 8 %, compared with that before the irradiation. With such shrinkage in the line width of the resist pattern, the line width can be adjusted more finely and variations in line width can be decreased. The line width of the resist pattern can be decreased by adjusting the irradiation amount of radiation all over the resist pattern, the heating temperature, the heating time, the material of resist film and the like within the range described above.

After forming the resist pattern according to the present invention, the layer to be etched is patterned by a known method using this resist pattern as a mask and further the resist pattern is removed, e.g., ashing. Thereby the patterning of the layer is completed.

The process for forming a photoresist pattern of the present invention is now described in detail with reference to the accompanying drawings.

### EXAMPLE 1

First, as shown in Fig. 1(a), a chemical amplification type resist film was rotationally applied onto a semiconductor substrate 3 having a polysilicon film 2 of 5,000Å thickness deposited on the top thereof. As the chemical amplification type resist film, used was TDUR-P034 produced by Tokyo Okasha, Japan. This resist film contains polyhydroxystyrene as the main chain and a dissolution inhibiting group (mainly a t-BOC group) is introduced to the hydroxyl group of polyhydroxystyrene. Then the soft baking step was carried out on a hot plate under a temperature of 110°C for a minute, thereby to form a resist film 1 of 0.7µm thickness.

Subsequently, as shown in Fig. 1(b), KrF excimer laser light 4 was irradiated to the resist film 1 through a mask 6. The excimer laser light had a wavelength of 248nm and was irradiated at an energy of 300 J/m² using a laser light generator ELS-4300 manufactured by Cymer. The reason for using this laser light was that this ultraviolet radiation was advantageous since it was easy to handle, highly monochromatic and able to induce the above-described chemical reaction effectively in the resist film 1. Then PEB (post exposure baking) was carried out to the resist film 1 on a hot plate at a temperature of 100°C for 100 seconds.

Next, as shown in Fig. 1(c), development was carried out with a 2.38% tetramethylammoniumhydroxide (TMAH) aqueous solution for 90 seconds to obtain a resist pattern 1A.

Then, as shown in Fig. 1(d), ultraviolet radiation 5 having a peak at a wavelength of 248nm was irradiated at an energy of 2,000 J/m² over the entire surface of the resist pattern 1A to eliminate t-butoxycarbonyl groups in the resist pattern 1A, with maintaining the temperature of the semiconductor substrate 3 at 25°C.

Next, as shown in Fig. 1(e), the underlying polysilicon film 2 was anisotropically etched using the obtained resist pattern 1A as a mask, with an etching device and a fluorine-containing gas, for example, CH₂F₂ or the like, to obtain a polysilicon film 2 having a predetermined shape.

Lastly, as shown in Fig. 1(f), the resist pattern 1A, a chemical amplification type resist film, was removed by ashing. For ashing, used was a surface-wave plasma ashing device produced by Sumitomo Metal Industries, Inc., Japan.

Table 1 shows the relationship between the line width of the resist pattern 1A after etching (post-etching line-width : the line width of the resist pattern 1A in Fig.1 (e)) and the etching rate of the resist film (resist etching rate). This table shows that the irradiation of radiation having a single peak at a particular wavelength reduces the resist etching rate remarkably. Table 1 also shows variations in the line width of the resist pattern 1A after etching (post-etching line-width variations). As shown in Example 1, post-etching line-width variations are decreased by irradiation of radiation after the formation of the pattern.

According to the above Example 1, by use of the positive resist film having the main chain of polymer in which at least a part of phenolic hydroxyl groups are substituted with protective groups which are ready to be eliminated by action of an acid, a resist pattern with high etching resistance and fewer line-width variations can be easily formed by irradiation with radiation such as ultraviolet radiation after the formation of the resist pattern 1A.

### COMPARATIVE EXAMPLE 1

In this comparative example, the irradiation with radiation after the formation of the resist pattern 1A of Example 1 as shown in Fig. 1(d) was omitted.

Table 1 shows results of Comparative Example 1. It is shown that the etching rate of the resist film is larger than that of Example 1.

### COMPARATIVE EXAMPLE 2

In this Comparative Example 2, a mercury lamp was used as a light source in the irradiation with radiation after the formation of the resist pattern 1A in Example 1 as shown in Fig. 1(d).

Table 1 shows results of Example 1 of Comparative Example 2. The etching rate of the resist film is lower than that of Comparative Example 1, but the variations in the line width of the resist pattern after etching are wider than those of Example 1. Also, remains of the resist film after ashing were observed.

**Table 1**

| Evaluation items | Example 1 | Com.Ex.1 | Com.Ex.2 |
|---|---|---|---|
| Pattern line width after development (nm)* | 240 | 241 | 242 |
| Pattern line width after etching (nm)** | 237 | 241 | 239 |
| post-etching line-width variations (3σ, nm) | 15 | 20 | 28 |
| Resist etching rate (nm/min.) | 110 | 200 | 120 |
| Remains of resist after ashing | Nil | Nil | observed |

| | | | |
|---|---|---|---|
| *:the resist pattern line width of Fig.1 (c) | | | |
| **:the resist pattern line width of Fig.1 (e) | | | |

### EXAMPLES 2 to 9

Referring to Fig. 1(a), a chemical amplification type resist film was rotationally applied on a semiconductor substrate 3 having a TiN film 2 of 1,000Å thickness formed on the top thereof. As the chemical amplification type resist film, PEK-101 produced by Sumitomo Chemical Industries Inc., Japan was used. This resist film had polyhydroxystyrene as the main chain to whose hydroxyl group the dissolution inhibiting group was introduced. Then heat treatment was carried out on a hot plate under a temperature of 90°C for one minute to form a resist film 1.

Subsequently, as shown in Fig. 1(b), the resist film 1 was irradiated with KrF excimer laser light 4 through a mask 6. This excimer laser light had a wavelength of 248nm and was irradiated at an energy of 350 J/m² using a prototype of an ArF excimer laser light generator produced by Komatsu, Japan. The reason for using this laser light was that this ultraviolet radiation was advantageous because it was easy to handle, highly monochromatic and able to induce the above chemical reaction effectively in the resist film 1. Then the resist film 1 was subjected to the soft baking step on a hot plate at a temperature of 110°C for 80 seconds.

Next, as shown in Fig. 1(c), the resist film 1 was subjected to development with a 2.38% tetramethylammoniumhydroxide aqueous solution for 90 seconds to obtain a resist pattern 1A.

Then, as shown in Fig. 1(d), ArF excimer laser light 5 (peak wavelength : 193 nm) was irradiated onto the entire surface of the resist pattern 1A (entire-surface irradiation), with maintaining the temperature of the semiconductor substrate 3 at 30°C.

In these Examples 2 to 9, the energy for the entire-surface irradiation according to the present process was varied as shown in Table 2. It is noted that, the steps before the entire-surface irradiation and the steps after that were the same in all of Examples 2 to 9.

Next, as shown in Fig. 1(e), using the obtained resist pattern 1A as a mask, the underlying TiN film 2 was anisotropically etched with an etching device using a chlorine-base gas, for example, Cl₂ or the like, to form a metal pattern.

Lastly, as shown in Fig. 1(f), the resist pattern 1A, a chemical amplification type resist film, which has been used as a mask, was removed by ashing.

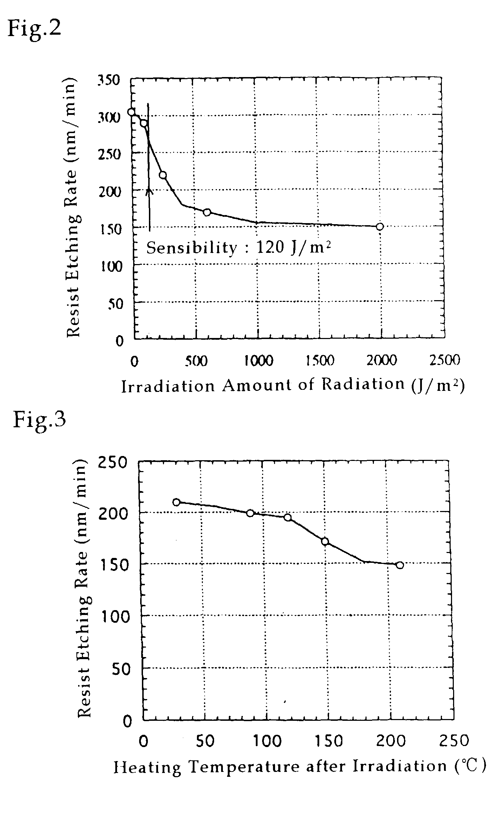

Fig. 2 shows the relationship between the energy for the entire-surface irradiation and the etching rate. Fig. 2 shows that the etching rate of the resist film is remarkably improved in cases where the energy for the entire-surface irradiation is double the sensitivity of resist film (in these examples, 120 J/m²) or higher.

**Table 2**

| | Energy for entire-surface irradiation (J/m²) | Energy intensity to sensitivity of resist film (times) | Etching Rate (nm/min.) |
|---|---|---|---|
| Example 2 | 50 | 0.42 | 300 |
| Example 3 | 100 | 0.83 | 290 |
| Example 4 | 150 | 1.25 | 240 |
| Example 5 | 250 | 2.08 | 220 |
| Example 6 | 400 | 3.33 | 215 |
| Example 7 | 600 | 5.00 | 211 |
| Example 8 | 1000 | 8.33 | 204 |
| Example 9 | 2000 | 16.67 | 200 |

### EXAMPLES 10 to 16

As shown in Fig. 1(a), a chemical amplification type resist film was rotationally applied on a semiconductor substrate 3 having a SiN film 2 of 1,000Å thickness formed on the top thereof. As the chemical amplification type resist film, a polymer containing methacrylic acid/3-oxocyclohexyl-2-methyl-2-adamatylmethacrylate copolymer as the major component was used. As the acid generator, a compound described below was used. 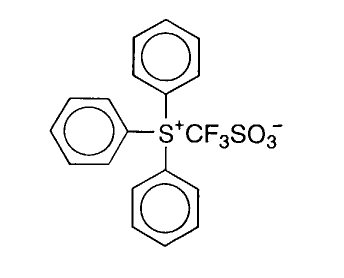 Then heat treatment was carried on a hot plate under a temperature of 130°C for two minutes thereby to form a resist film 1 of 0.4µm thickness. Heating temperature is not limited to 130°C, but may be 100 to 140°C, preferably 125 to 135°C. This is because this range of temperature provides a good shape for the resist pattern.

Subsequently, as shown in Fig. 1(b), the resist film 1 was irradiated with ArF excimer laser light 4 through a mask 6. This excimer laser light had a wavelength of 193nm and was irradiated at an energy of 100 J/m² using a prototype of an ArF excimer laser light generator produced by Cymer. The reason for using this laser light was that this ultraviolet radiation was advantageous because it was easy to handle, highly monochromatic and able to induce the aforesaid chemical reaction effectively.

Then, as shown in Fig. 1(c), the resist film 1 was heated on a hot plate at a temperature of 150°C for 80 seconds as a PEB and then was subjected to development with a 0.12wt% TMAH aqueous solution for 90 seconds to obtain a resist pattern 1A.

Then, as shown in Fig. 1(d), ArF excimer laser (193mm) was irradiated at energy of 2,000 J/m² over the resist pattern 1 A, with maintaining the temperature of the semiconductor substrate 3 at 100°C or lower. The ArF excimer laser light was generated by a prototype of an ArF excimer laser light generator produced by Komatsu, Japan. The reason for using this laser light was that this ultraviolet light was advantageous because it was easy to handle, highly monochromatic and able to induce the aforesaid chemical reaction effectively.

Subsequently, the semiconductor substrate 3 was heated. The temperature of the semiconductor substrate 3 (substrate heating temperature) was varied in Examples 10 to 16 as shown in Table 3. It is noted that all steps were the same in Examples 10 to 16 except that the temperature of the semiconductor substrate 3 was varied.

**Table 3**

| | Substrate Heating Temperature (°C) |
|---|---|
| Example 10 | 30 |
| Example 11 | 60 |
| Example 12 | 90 |
| Example 13 | 120 |
| Example 14 | 150 |
| Example 15 | 180 |
| Example 16 | 210 |

Next, as shown in Fig. 1(e), using the obtained resist pattern 1A as a mask, the underlying SiN film 2 was anisotropically etched with an etching device using a fluorine-containing gas, for example, CHF₃ or the like, thereby to transfer the pattern to the underlying layer.

Lastly, as shown in Fig. 1(f), the chemical amplification resist pattern 1A was removed by ashing.

Fig. 3 shows the relationship between the substrate heating temperature after the entire-surface irradiation and the etching rate. This figure shows that the etching rate of resist film is more improved (i.e., decreased) in the case where the substrate heating temperature after the entire-surface irradiation is higher than the temperature in the PEB step (150°C in this example) than in the case where the resist film is only entirely irradiated.

### EXAMPLES 17 to 25

As shown in Fig. 1(a), a chemical amplification type resist film was rotationally applied on a semiconductor substrate 3 having a SiO₂ film 2 of 5,000Å thickness formed on the top thereof. As the chemical amplification type resist film, SEPR-4103PH produced by Shinetsu Kagaku, Japan was used. This resist film contains polyhydroxystyrene as main chain to whose hydroxyl group the dissolution inhibiting group is introduced. In these examples, several resist films whose hydroxyl groups were protected in different ratios were prepared. Then heat treatment was carried under a temperature of 90°C for two minutes thereby to form a resist film 1 of 0.8µm thickness.

Subsequently, as shown in Fig. 1(b), the resist film 1 was irradiated with KrF excimer laser light 4 through a mask 6. This KrF excimer laser light (248nm) was irradiated at an energy of 600 J/m² using KrF excimer laser light generator ELS-4300 produced by Cymer.

Then, as shown in Fig. 1(c), the resist film 1 was heated on a hot plate at a temperature of 110°C for 80 seconds, and then was subjected to development with a 2.38% tetramethylammoniumhydroxide aqueous solution for 90 seconds thereby to obtain a resist pattern 1A.

Then, as shown in Fig. 1(d), Xe excimer lamp light adapted to have a single peak (172 nm) was irradiated onto the entire surface of the resist pattern 1A, with maintaining the temperature of the semiconductor substrate 3 at 50°C. Subsequently, the semiconductor substrate 3 was heated at a temperature as shown in Table 4 (heating temperature after the entire-surface irradiation) to such a degree that the resist pattern 1A was not deformed as PEB.

In these examples, the refraction index of the resist films was varied in the range of 1.55 to 1.64 by changing, as shown in Table 4, the protection ratio of the hydroxyl groups of the resist film, the intensity of the entire-surface irradiation and the heating temperature after the entire-surface irradiation in the above steps.

Next, as shown in Fig. 1(e), using the obtained resist pattern 1A as a mask, the underlying SiO₂ film 2 was anisotropically etched with an etching device using a mixture gas containing a fluorine-base gas, for example, a mixture gas of CF4 and H2, thereby to transfer the pattern to the underlying SiO₂ film 2.

Lastly, as shown in Fig. 1(f), the resist pattern 1A was removed by ashing.

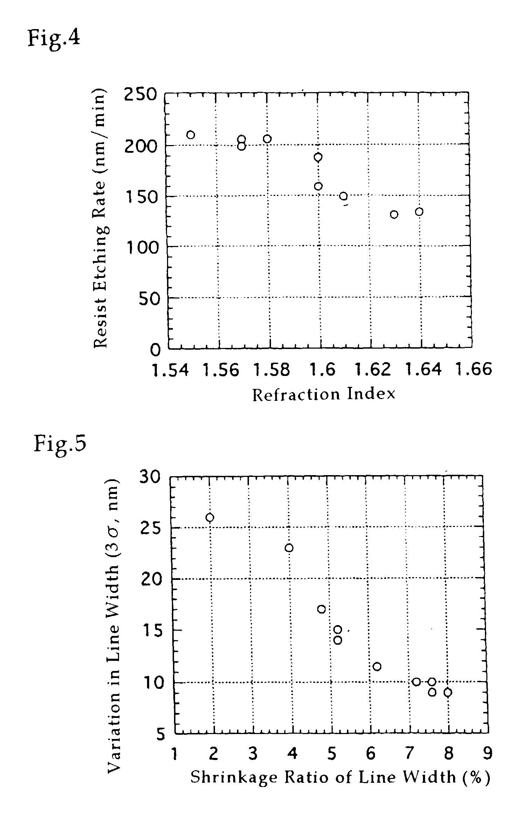

Fig. 4 shows the relationship between the refraction indices of resist film obtained through the above steps and the etching rate. This figure shows that the etching rate of the resist film is remarkably improved (i.e., decreased) in the case where the refraction index of resist film rises by 3% or more from the refraction index before irradiation.

**Table 4**

| | Protection ratio of OH groups (%) | Intensity of entire-surface irradiation (J/m²) | Heating temp. after entire-surface irradiation (°C) | Refraction index of resist film | Increase ratio of refraction Index (%) |
|---|---|---|---|---|---|
| Example 17 | 30 | 500 | 100 | 1.55 | 0.6 |
| Example 18 | 30 | 1500 | 140 | 1.58 | 2.6 |
| Example 19 | 30 | 5000 | 180 | 1.63 | 5.8 |
| Example 20 | 35 | 500 | 140 | 1.57 | 1.9 |
| Example 21 | 35 | 1500 | 180 | 1.60 | 3.9 |
| Example 22 | 35 | 5000 | 100 | 1.57 | 1.9 |
| Example 23 | 40 | 500 | 180 | 1.61 | 4.5 |
| Example 24 | 40 | 1500 | 100 | 1.60 | 3.9 |
| Example 25 | 40 | 5000 | 140 | 1.64 | 6.5 |

### EXAMPLES 26 to 34

As shown in Fig. 1(a), a chemical amplification type resist film was rotationally applied on a semiconductor substrate 3 having a SiN film 2 of 1,000Å thickness formed on the top thereof. As the chemical amplification type resist film, methacrylic acid/3-oxocyclohexyl-2-methyl-2-adamantylmethacrylate copolymer was used. Then, heating treatment was carried out on a hot plate under a temperature of 130°C for two minutes thereby to form a resist film 1 of 0.4µm thickness.

Subsequently, as shown in Fig. 1(b), the resist film 1 was irradiated with ArF excimer laser light 4 through a mask 6. This excimer laser light (193 nm) was irradiated at an energy of 100 J/m² using a prototype of an ArF excimer laser light generator produced by Cymer.

Then, as shown in Fig. 1(c), the resist film 1 was heated on a hot plate at a temperature of 150°C for 80 seconds, and then was subjected to development with a 0.12wt% TMAH aqueous solution for 90 seconds thereby to obtain a resist pattern 1A.

Then, as shown in Fig. 1(d), an ArF excimer laser light (193nm) is irradiated at an energy of 3,000 J/m² over the entire surface of the resist pattern 1A, with maintaining the temperature of the semiconductor substrate 3 at 50°C. Subsequently, the semiconductor substrate 3 was heated to a temperature as shown in Table 5 (substrate heating temperature after the entire-surface irradiation).

In Examples 26 to 34, the proportion of the 2-methyl-2-adamantyl (2M2A) in the chemical amplification type resist film in the copolymer and the substrate heating temperature after the entire-surface irradiation were varied as shown in Table 5.

**Table 5**

| | Proportion of 2M2A (%) | heating temp. after entire-surface irradiation (°C) | Line width after etching (nm) | Shrinkage ratio of line width (%) | Size controllability (3 a) (nm) |
|---|---|---|---|---|---|
| Com.Ex.3 | 50 | 120 | 245 | 2.0 | 26 |
| Example 26 | 40 | 120 | 240 | 4.0 | 20 |
| Example 27 | 50 | 120 | 237 | 5.2 | 15 |
| Example 28 | 60 | 120 | 230 | 8.0 | 9 |
| Example 29 | 40 | 150 | 238 | 4.8 | 17 |
| Example 30 | 50 | 150 | 233 | 6.8 | 12 |
| Example 31 | 60 | 150 | 231 | 7.6 | 10 |
| Example 32 | 40 | 180 | 237 | 5.2 | 14 |
| Example 33 | 50 | 180 | 232 | 7.2 | 10 |
| Example 34 | 60 | 180 | 231 | 7.6 | 9 |

Next, as shown in Fig. 1(e), using the obtained resist pattern 1A as a mask, the underlying SiN film 2 was anisotropically etched with an etching device using a fluorine-base gas, for example, CHF3 or the like, thereby to transfer the pattern to the underlying SiN film 2.

Lastly, as shown in Fig. I(f), the chemical amplification type resist film 1 having been used as a mask was removed by ashing.

Fig. 5 shows the relationship between variations in line width of resist pattern after the formation of the resist pattern and the shrinkage ratio of line width. This figure shows that variations in line width after etching decrease in the case where the line width of the resist pattern after the entire-surface irradiation and the heating of the semiconductor substrate reduces by 5% or more compared with the line width of the resist pattern before irradiation.

According to the process for forming a resist pattern of the present invention, the protection groups of the chemical amplification type resist film can be completely eliminated by irradiating the entire surface of the chemical amplification type resist film with radiation having a single peak at a particular wavelength after the formation of the resist pattern. This contributes to the improvement of the etching resistance of the resist film. Especially, even in the case of a chemical amplification type resist film poor in etching resistance which contains as the major component a polymer in which OH groups of polyvinyl phenol are protected by protective groups at least in part, the protective groups can be separated from the main chain with maintaining a polymeric film below the glass transition point of the polymer. Therefore the etching resistance can be sufficiently ensured. Further, by use of a light source having a single peak at a particular wavelength, the resist film can be prevented from being heated compared with the case where a conventional light source is used at the irradiation, and variations in the line width of the resist pattern can be reduced. For these reasons, the utilization of the present invention enables a resist pattern of high etching resistance to be easily formed with high accuracy, and therefore the present invention will contribute greatly to manufacture of high-density integrated circuits.

Furthermore, because the heating of the semiconductor substrate after the entire-surface irradiation of the resist pattern with radiation eliminates protective groups which are not eliminated by the entire-surface irradiation, the etching resistance of the chemical amplification type resist film is significantly improved. This shows that the present invention also provides an effective means for improving the etching resistance even of a resist film containing as the main component a polymer whose protective groups do not come off readily.

Further, the etching resistance of the resist pattern can be positively improved by setting the energy of radiation equal to or more than double the sensibility in the step of providing the etching resistance.

Further, the etching rate of the chemical amplification type resist film can be forecast by checking changes of the refraction index of the resist film. That enables establishment of a more positive process for forming good resist patterns.

Further, by shrinking the line width of the resist pattern after the entire-surface irradiation by 5% or more, variations in the line width of the pattern can be controlled.

## Claims

1. A process for forming a photoresist pattern comprising the steps of:
applying a chemical amplification type positive resist film on a layer to be etched, followed by exposing and developing, thereby to form a resist pattern, and
irradiating an entire surface of the resist pattern with radiation having a single peak at a particular wavelength.

2. A process for forming a photoresist pattern according to claim 1 further comprising the step of heating the resist pattern as well as the layer to be etched after irradiation.

3. A process for forming a photoresist pattern according to claim 1 or 2, wherein the irradiation amount of radiation is more than or equal to double the sensibility of the chemical amplification type positive resist film.

4. A process for forming a photoresist pattern according to claim 1, wherein refractive index of the resist film to light is increased 3% or more after irradiation, compared with the refractive index before the irradiation.

5. A process for forming a photoresist pattern according to claim 1, wherein line width of the resist pattern is shrunk 5% or more after irradiation, compared with the width of the lines of the resist pattern before the irradiation.

6. A process for forming a photoresist pattern in which a chemical amplification type resist film on a layer to be etched is pattern irradiated and developed, and then flood irradiated with light having a single wavelength peak to make the resist film portions remaining after development highly etch resistant.
